(19)

**Europäisches Patentamt**
**European Patent Office**
**Office européen des brevets**

(11) **EP 4 708 682 A1**

(12) **EUROPEAN PATENT APPLICATION**

(43) Date of publication:
**11.03.2026 Bulletin 2026/11**

(21) Application number: **24199474.8**

(22) Date of filing: **10.09.2024**

(51) International Patent Classification (IPC):
*H03G 1/00* (2006.01)     *H03F 3/45* (2006.01)
*G06G 7/12* (2006.01)     *G06G 7/24* (2006.01)
*H03G 7/06* (2006.01)     *H03G 3/30* (2006.01)

(52) Cooperative Patent Classification (CPC):
**H03G 1/0023; G06G 7/12; G06G 7/24;**
**H03F 3/4508; H03F 3/45085; H03G 1/007;**
**H03G 1/0082; H03G 3/3036; H03G 3/3042;**
**H03G 7/06;** H03G 2201/103; H03G 2201/30;
H03G 2201/307

(84) Designated Contracting States:
**AL AT BE BG CH CY CZ DE DK EE ES FI FR GB**
**GR HR HU IE IS IT LI LT LU LV MC ME MK MT NL**
**NO PL PT RO RS SE SI SK SM TR**
Designated Extension States:
**BA**
Designated Validation States:
**GE KH MA MD TN**

(71) Applicant: **NXP B.V.**
**5656 AG Eindhoven (NL)**

(72) Inventors:
• **YANG, Xin**
  **5656 AE Eindhoven (NL)**
• **JANSSON, Lars Gustaf**
  **164 46 Krista (SE)**

(74) Representative: **Hardingham, Christopher Mark**
**NXP Semiconductors**
**Intellectual Property Group**
**The Cattle Barn**
**Upper Ashfield Farm, Hoe Lane**
**Romsey, Hampshire SO51 9NJ (GB)**

(54) **CURRENT CONVERTER CIRCUIT**

(57)     The disclosure relates to a current converter circuit (600) for converting a linear input current (Ictrl_lin) to an exponential output current (Ictrl_sum), the current converter circuit (600) comprising first and second current converters (601, 602), each of which comprises: an input current branch ($603_1$, $603_2$) with an input current source ($604_1$, $604_2$) connected in series with a tuning voltage circuit ($605_1$, $605_2$) and a tuning resistor ($606_1$, $606_2$) between a supply voltage line (607) and a common voltage line (608); and an output current branch ($609_1$, $609_2$) with an output transistor ($610_1$, $610_2$) having a collector connected to an output node ($611_1$, $611_2$), a emitter connected to the common voltage line (608) and a base connected to the tuning voltage circuit ($605_1$, $605_2$), wherein the output nodes ($611_1$, $611_2$) of the first and second current converters (601, 602) are connected to a summing output node (612) of the current converter circuit (600).

Fig. 6

EP 4 708 682 A1

## Description

Field

The disclosure relates to a current converter circuit.

Background

A variable gain amplifier (VGA) requires a control input for defining a gain of the VGA. In applications such as RF transmitters, a VGA is a component in the transmission line between a RF signal input and an RF antenna output. Gain control of the VGA may require a signal that varies exponentially, driven by a linearly varying gain control signal. A converter is therefore required in such cases that converts a linearly varying input control signal to an exponentially varying output control signal. A current converter circuit may form part of circuit for providing such gain control, in which a linearly varying input current is converted to an exponentially varying output current, which is then converted to a gain control voltage signal provided to the VGA. A problem with existing current converter circuits for providing such control is being able to maintain a uniformly varying output over typically several orders of magnitude.

Summary

According to a first aspect there is provided a current converter circuit for converting a linear input current to an exponential output current, the current converter circuit comprising first and second current converters, each of which comprises:

an input current branch with an input current source connected in series with a tuning voltage circuit and a tuning resistor between a supply voltage line and a common voltage line; and
an output current branch with an output transistor having a collector connected to an output node, an emitter connected to the common voltage line and a base connected to the tuning voltage circuit, wherein the output nodes of the first and second current converters are connected to a summing output node of the current converter circuit.

The tuning voltage circuit of each of the first and second current converters optionally comprises a diode-connected NPN transistor and a diode-connected MOS transistor.

In some examples the diode-connected NPN transistor is an input transistor having a collector connected to the input current source, an emitter connected to the tuning resistor and a base connected to the base of the output transistor.

The diode connected MOS transistor may be a tuning transistor having a gate connected to the input current source, a source connected to the base of the input and output transistors and a drain connected to the supply voltage line.

The base of the output transistor of each of the first and second current converters may be connected to the tuning voltage circuit via the tuning resistor.

In some examples the tuning voltage circuit of each of the first and second current converters comprises a voltage regulator and a tuning transistor, the voltage regulator having a first input for receiving a tuning voltage signal and a second input connected to a gate of the tuning transistor, an output of the voltage regulator connected to a drain of the tuning transistor and a source of the tuning transistor connected to the common voltage line.

The tuning resistor of each of the current converters may be adjustable.

In some examples, the input current source of each of the first and second current converters comprises a current source transistor having a gate connected to an input node of the current converter circuit, a source connected to the supply voltage line and a drain connected to the tuning voltage circuit.

According to a second aspect there is provided a gain control circuit for a variable gain amplifier, comprising:

a current converter circuit according to the first aspect;
a current to voltage converter circuit connected to the output current branch and configured to convert an output current through the output current branch to a differential output voltage signal.

In some examples the current to voltage converter circuit is a complementary differential amplifier configured to convert a single-ended current from the output current branch to the differential output voltage signal.

According to a third aspect there is provided a variable gain RF amplifier comprising:

an RF input;
an RF output;
a Gilbert Cell amplifier connected between the RF input and RF output; and
a gain control circuit according to the second aspect, wherein the differential output signal is connected to control a gain of the Gilbert Cell amplifier.

According to a fourth aspect there is provided a transmitter comprising a plurality of channels, each channel comprising a variable gain RF amplifier according to the third aspect, a power amplifier and an antenna.

Each of the plurality of channels may comprise a coarse phase shifter and a fine phase shifter, the variable gain RF amplifier, coarse phase shifter and fine phase shifter being connected in line to provide an amplified phase shifted signal to the power amplifier.

These and other aspects of the invention will be apparent from, and elucidated with reference to, the embodiments described hereinafter.

Brief description of Drawings

Embodiments will be described, by way of example only, with reference to the drawings, in which:

Figure 1 is a schematic diagram of an example 2-channel transmitter for an analog beamforming circuit;

Figure 2 is a schematic diagram of an example variable gain amplifier circuit;

Figure 3 is a block diagram illustrating an example arrangement for the gain and phase control circuit of Figure 2;

Figure 4 is a schematic circuit diagram of an example current to current (121) and current to voltage (12V) circuit for the arrangement of Figure 3;

Figure 5 is an example plot of VGA gain as a function of input gain control code using the circuit of Figure 4;

Figure 6 is a schematic circuit diagram of an example 121 circuit;

Figures 7a-7d are example plots of output current as a function of input current for the circuit of Figure 6;

Figure 8 is an example plot of VGA gain as a function of input gain control code using the circuit of Figure 6;

Figure 9 is an example plot of gain step per unit code change as a function of input gain control code using the circuit of Figure 6;

Figure 10 is a schematic circuit diagram of an example I2I circuit and a corresponding representation of the I2I circuit;

Figure 11a is a plot of output current as a function of input current for an example I2I circuit with a fixed tuning voltage and different tuning resistor values;

Figure 11b is a plot of output current as a function of input current for an example I2I circuit with a fixed tuning resistor and different tuning voltages;

Figure 12a is a plot of output current as a function of input current for an example I2I circuit with a fixed tuning voltage and different tuning resistor values;

Figure 12b is a plot of a derivative of output current as a function of tuning resistance with a fixed tuning voltage;

Figure 12c is a plot of output current as a function of input current for an example I2I circuit with a first tuning resistance and different tuning voltages;

Figure 12d is a plot of a derivative of output current as a function of tuning voltage with a fixed tuning resistance;

Figure 13 is a schematic simplified circuit diagram of an example I2I circuit;

Figure 14 is a schematic circuit diagram of an example implementation of the circuit of Figure 13; and

Figure 15 is a schematic circuit diagram of an example alternative I2I circuit comprising multiple parallel current to current converter circuits.

It should be noted that the Figures are diagrammatic and not drawn to scale. Relative dimensions and proportions of parts of these Figures have been shown exaggerated or reduced in size, for the sake of clarity and convenience in the drawings. The same reference signs are generally used to refer to corresponding or similar feature in modified and different embodiments.

Detailed description of embodiments

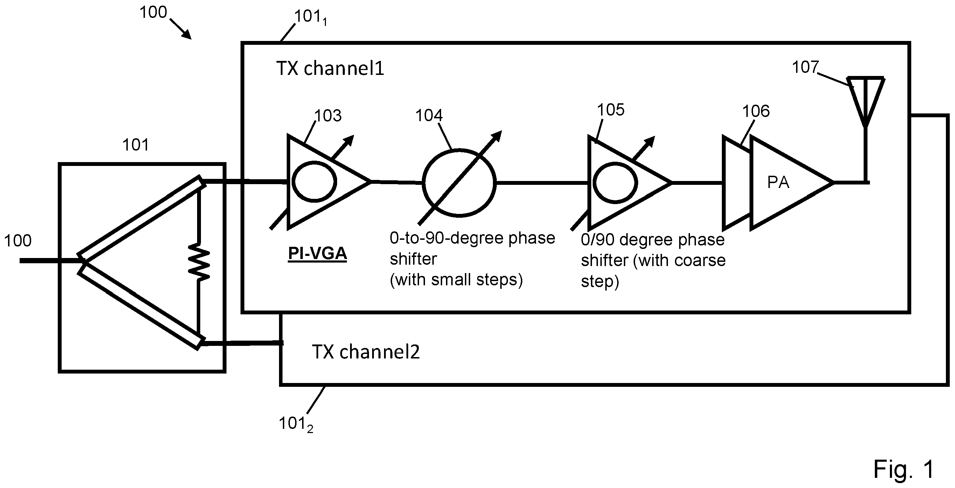

An example of a transmitter (TX) line 100 comprising two channels $101_1$, $101_2$ is illustrated in Figure 1, which represents various components of an analog beamforming integrated circuit (IC). Each channel $101_1$, $101_2$ comprises a VGA, in this example a phase-inverting VGA (PI-VGA) 103, a fine 0 to 90 degree phase shifter 104, a coarse 0/90 degree phase shifter 105 and a power amplifier (PA) 106, which outputs an amplified RF signal to an antenna 107. The fine 0 to 90 degree phase shifter 104 applies a phase shift in relatively small steps, for example in steps covering 0, 5.625, 11.24, ... 84.375, and 90 degrees, and may be implemented with a passive reflective-type phase shifter (RTPS). The coarse 0/90 degree phase shifter 105 applies a phase shift in larger steps of 90° and may be implemented by passive or active components. In combination, the phase shifters 104, 105 apply a desired phase shift to the signal provided to the power amplifier 106. For an application such as an analog beamformer or a phased array system, control of the phase of the output signal over a full 360° is required for each channel. For this, the PI-VGA 103 is used to achieve a desired 0/180° phase shift in combination with the coarse 0/90° phase shifter 105 and the fine 0-to-90° phase shifter.

The PI-VGA 103 comprises a VGA with a linear control input that controls a gain of the VGA in dB. The PI-VGA 103 has two functions: tapering gain control and 0/180 degree phase shifting. For tapering gain control, the gain required in dB is ideally proportional to the input linear control code.

The order in which the components 103, 104, 105 is provided in each channel $101_1$, $101_2$ may vary from that shown in Figure 1, for example by applying one or both of the phase shifters 104, 105 before the PI-VGA 103. The PI-VGA 103 of the type described herein may also be used in other types of transmitter lines and in other applications such as in a receiver line or IQ modulator.

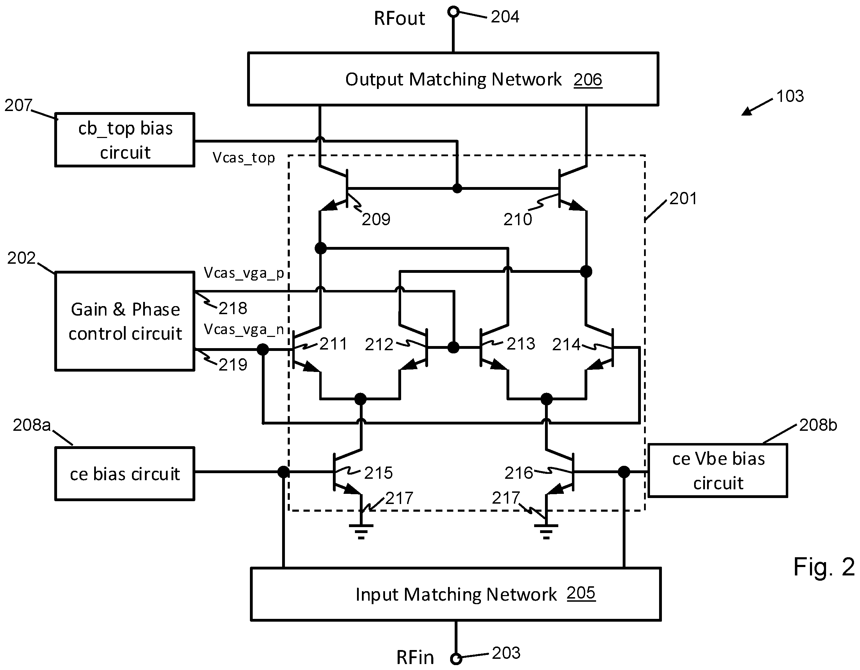

Figure 2 illustrates an example PI-VGA unit cell core 103 of the type described above in relation to Figure 1. An analog bias circuit for the PI-VGA is not shown. The PI-VGA 103 comprises a classical Gilbert Cell 201 with a top common-base (current re-used) buffer. The top common-base buffer significantly improves the RF performance in both the Gain-to-Phase error and linearity. A gain and phase control bias circuit 202 provides a differential gain control signal Vcas_vga_p, Vcas_vga_n to the Gilbert cell.

The VGA 103 comprises an RF input 203 and an RF output 204. An input matching network 205 is connected between the RF input 202 and the Gilbert cell amplifier 201. An output matching network 206 is connected between the Gilbert cell amplifier 201 and the RF output 204.

Bias circuits 207, 208a, 208b apply bias voltage signals to various transistors making up the Gilbert cell 201, which in this example are bipolar junction transistors. A common base top bias circuit 207 applies a bias voltage to the base of each of first and second transistors 209, 210. An emitter of each of the first and second transistors 209, 210 is connected to the output matching network 206. A source of the first transistor 209 is connected to an emitter of a third transistor 211 and a fifth transistor. A source of the second transistor 210 is connected to an emitter of a fourth transistor 212 and a sixth transistor 214. A first output 218 of the gain and phase control circuit 202, providing Vcas_vga_p, is connected to a base of the fourth transistor 212 and fifth transistor 213. A second output 219 of the gain and phase control circuit 202, providing Vcas_vga_n, is connected to a base of the third transistor 211 and sixth transistor 214. Sources of the third transistor 211 and fourth transistor 212 are connected to an emitter of a seventh transistor 215. Sources of the fifth transistor 213 and sixth transistor 214 are connected to an emitter of an eight transistor 217. A base of the seventh transistor is connected to a first common emitter bias circuit 208a and to the input matching network 205. A base of the eight transistor is connected to a second common emitter bias circuit 208b and to the input matching network 205. Sources of the seventh and eighth transistors 215, 216 are connected to a common voltage rail 217 (e.g. a ground connection).

When the gain of VGA 103 is high, the differential bias voltage applied by Vcas_vga_p and Vcas_vga_n is high (for example a 200 mV voltage difference).

To decrease the gain of the VGA, this voltage difference is decreased. The physical behaviour of the Gilbert cell VGA 103 is that the gain of the VGA 103 in dB is proportional to the bias voltage difference in dB, i.e. $\log(\text{Gain}) \propto \log(\text{Vdiff})$, where in this case Vdiff = Vcas_vga_p - Vcas_vga_n. What is required is for the gain of the VGA 103 in dB to be proportional to the linear control current in magnitude, i.e. $\log(\text{Gain}) \propto \text{Ictrl\_lin}$. The bias voltage difference therefore needs to be in magnitude exponential in relation to the control current in magnitude, i.e. $\text{Vdiff} \propto \exp(\text{Ictrl\_lin})$.

Phase inverting the output of the VGA 103 is achieved by swapping the bias voltage of Vcas_vga_p and Vcas_vga_n. In one phase setting, Vcas_vga_p > Vcas_vga_n, which can be inverted to achieve a 180-degree phase shift, i.e. swapping the voltages to make Vcas_vga_p < Vcas_vga_n.

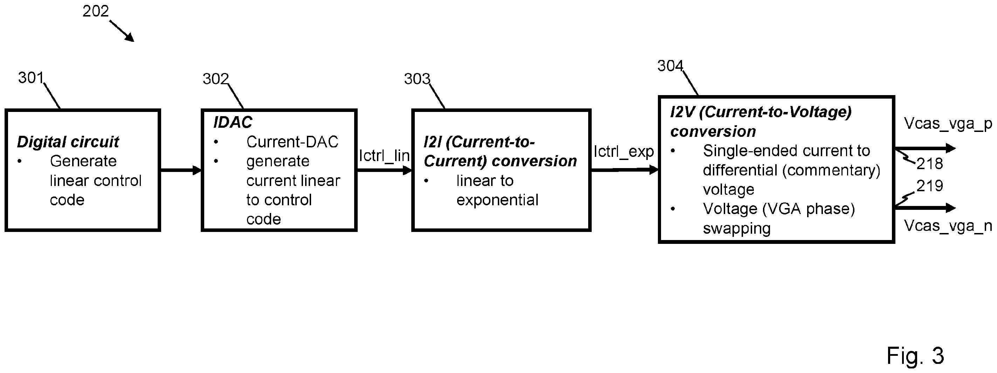

Figure 3 illustrates a schematic block diagram of an example gain and phase control circuit 202 to generate the differential bias voltage: Vcas_vga_p and Vcas_vga_n. The circuit 202 comprises a digital circuit 301, which generates a digital linearly varying control code. This control code is provided to a digital to analog converter 302, which converts the digital control code to a linearly varying control current, Ictrl_lin. This control current is provided to a current-to-current (I2I) converter 303, which converts the linearly varying control current Ictrl_lin to an exponentially varying control current Ictrl_exp. The exponentially varying control current Ictrl_exp is provided to a current-to-voltage (I2V) converter 304, which outputs the differential bias voltage Vcas_vga_p and Vcas_vga_n at first and second outputs 218, 219.

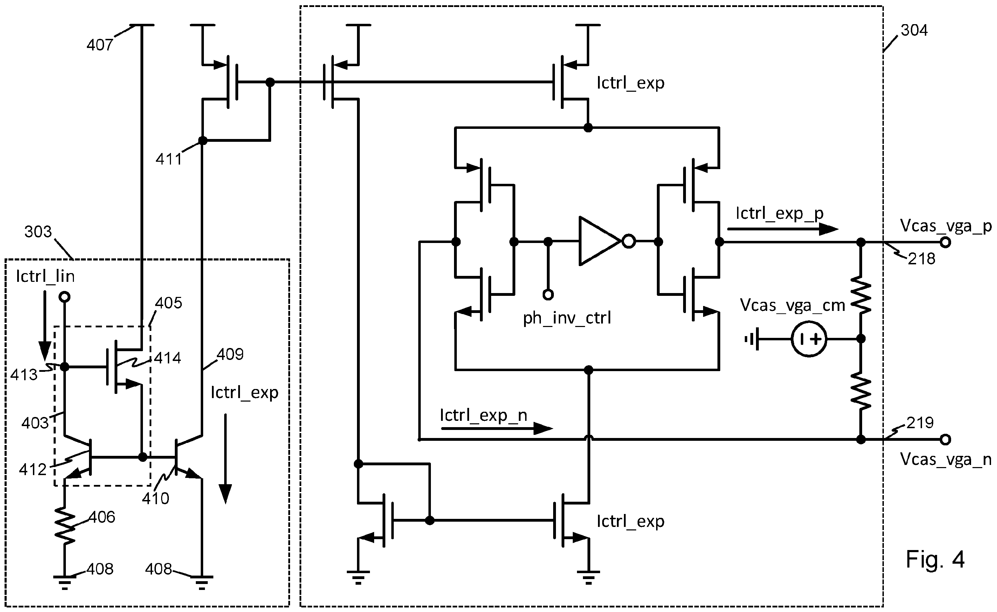

Figure 4 illustrates an example of the I2I and I2V converter circuits 303, 304 of Figure 3. The linearly varying control current Ictrl_lin (which may include a fixed current component I_fix) is provided to an input current branch 403 of the I2I converter circuit 303, which comprises a tuning voltage circuit 405 and a tuning resistor 406 between a supply voltage line 407 and a common voltage line 408. An output current branch 409 of the I2I converter circuit 303 comprises an output transistor 410 having a drain connected to an output node 411, a source connected to the common voltage line 408 and a base connected to the tuning voltage circuit 405.

The tuning voltage circuit 405 in this example comprises an input transistor 412 having an emitter connected to an input node 413, a source connected to the tuning resistor 406 and a base connected to the base of the output transistor 410. The input and output transistors 412, 410 are in this example bipolar junction transistors. The tuning voltage circuit 405 also comprises a tuning transistor 414 having a gate connected to the input node 413, a source connected to the base of the input and output transistors 412, 410 and a drain connected to the supply voltage line 407. The tuning transistor 414 in this example is a FET.

The linearly varying control current Ictrl_lin is provided by the current DAC 302, which generates an output current proportional to the input gain code, and therefore varies in equal steps as the input gain code varies. A fixed current source I_fix may provide a current offset to the linearly varying control current, such that Ictrl_lin = I_fix + I_step*Gain_code, where Gain_code is the input gain code and I_step is the unit step change in current for a single bit change in the input gain code.

The I2V converter circuit 304 is a complementary differential amplifier that converts the single-ended exponentially varying output current Ictrl_exp from the I2I converter circuit 303 to a differential voltage output Vcas_vga_p, Vcas_vga_n at the first and second outputs 218, 219. A phase inverting input 415 allows a phase inverting control signal ph_inv_ctrl to switch the outputs to invert the phase of the Gilbert cell amplifier 201. An example of a complementary differential amplifier for use as the I2V converter circuit 304 is disclosed by M. Bazes, "Two novel fully complementary self-biased CMOS differential amplifiers," in IEEE Journal of Solid-State Circuits, vol. 26, no. 2, pp. 165-168, Feb. 1991, doi: 10.1109/4.68134.

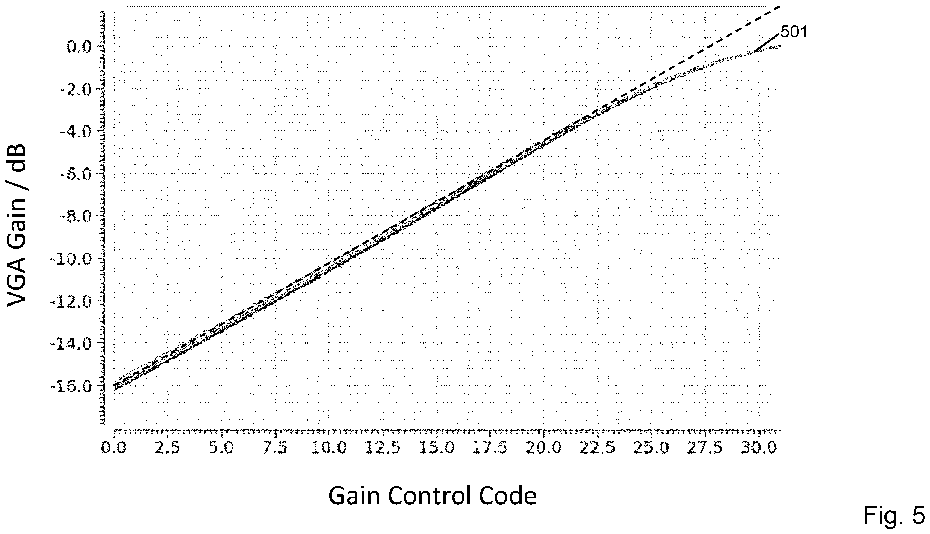

Figure 5 is a plot of VGA gain as a function of gain control code, with the gain varying from -16dB to 0dB as the gain control code varies from 0 to 31 (i.e. over a 5 bit range). It can be seen from this that the VGA gain 501 departs from linearity when the gain control code is over 24, indicating that the VGA gain step is no longer constant. In order to maintain linear control, the maximum gain control code can be set to 24, meaning that the VGA is working with a back-off of in this example around 2 dB. It would be advantageous to be able to operate the VGA in a linear gain control region beyond this range, which benefits linearity and noise of the VGA.

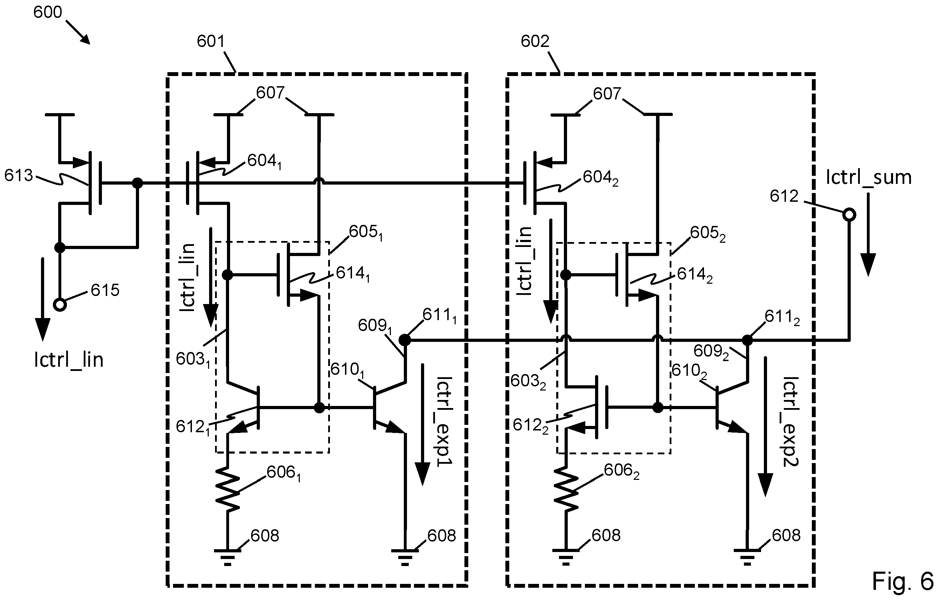

Figure 6 illustrates an example current converter circuit 600 to replace the current converter circuit 303 of Figure 4 that solves the above problem. The current converter circuit 600 comprises first and second current converters 601, 602, each of which is similar to the single current converter circuit 303 of Figure 4. Each current converter 601, 602 comprises an input current branch $603_1$, $603_2$ and an output current branch $609_1$, $609_2$, with an output node $611_1$, $611_2$ of the first and second current converters 601, 602 connected to a summing output node 612 of the current converter circuit 600.

The input current branch $603_1$, $603_2$ of each current converter 601, 602 comprises an input current source $604_1$, $604_2$ connected in series with a tuning voltage circuit $605_1$, $605_2$ and a tuning resistor $606_1$, $606_2$ between a supply voltage line 607 and a common voltage line 608 (e.g. a ground connection). The output current branch $609_1$, $609_2$ comprises an output transistor $610_1$, $610_2$ having a common connection connected to an output node $611_1$, a source connected to the common voltage line 608 and a base connected to the tuning voltage circuit $605_1$, $605_2$.

The tuning voltage circuit $605_1$, $605_2$ of each of the first and second current converters 601, 602 in this example comprises an input transistor $612_1$, $612_2$ in the form of a diode-connected NPN transistor having a common connection connected to the input current source $604_1$, $604_2$, an emitter connected to the tuning resistor $606_1$, $606_2$ and a base connected to the base of the output transistor $610_1$, $610_2$. The input and output transistors $612_1$, $612_2$, $610_1$, $610_2$ are in this example NPN bipolar junction transistors. The tuning voltage circuit $605_1$, $605_2$ also comprises a diode connected MOS transistor in the form of a tuning transistor $614_1$, $614_2$ having a gate connected to the input current source $604_1$, $604_2$, a source connected to the base of the input and output transistors $612_1$, $612_2$, $610_1$, $610_2$ and a drain connected to the supply voltage line 607. The tuning transistors $614_1$, $614_2$ are in this example NFETs. In alternative examples, the tuning transistors $614_1$, $614_2$ may be replaced by NPN BJTs or other types of transistors.

The current source $604_1$, $604_2$ in each of the first and second current converter 601, 602 comprise a current source transistor having a gate connected to an input node 615 of the current converter circuit 600, a source connected to the supply voltage line 607 and a drain connected to the tuning voltage circuit $605_1$, $605_2$, i.e. in this example to the gate of the tuning transistor $614_1$, $614_2$ and the common connection of the input transistor $612_1$, $612_2$. The current source transistors $604_1$, $604_2$ are in this example PFETs. In alternative examples, the current source transistors $604_1$, $604_2$ may be replaced by PNP BJTs or other types of transistors.

The linear input current Ictrl_lin is provided to each input current source $604_1$, $604_2$ via a common input current source transistor 613, which in this example is a PFET having a source connected to the supply voltage line 607, a gate connected to the gate of the input current source 6041, 6042 of each of the first and second current converters 601, 602 and with the drain and gate connected together and to the current input node 615.

Adding an extra I2I converter 602 in parallel with the first converter 601 and summing the output currents to provide a summed output current Ictrl_sum, i.e. such that Ictrl_sum = Ictrl_exp1 + Ictrlexp2, has the effect of extending the range of the current converter before the output current Ictrl_sum departs from linearity on a plot of gain in dB as a function of linear input current.

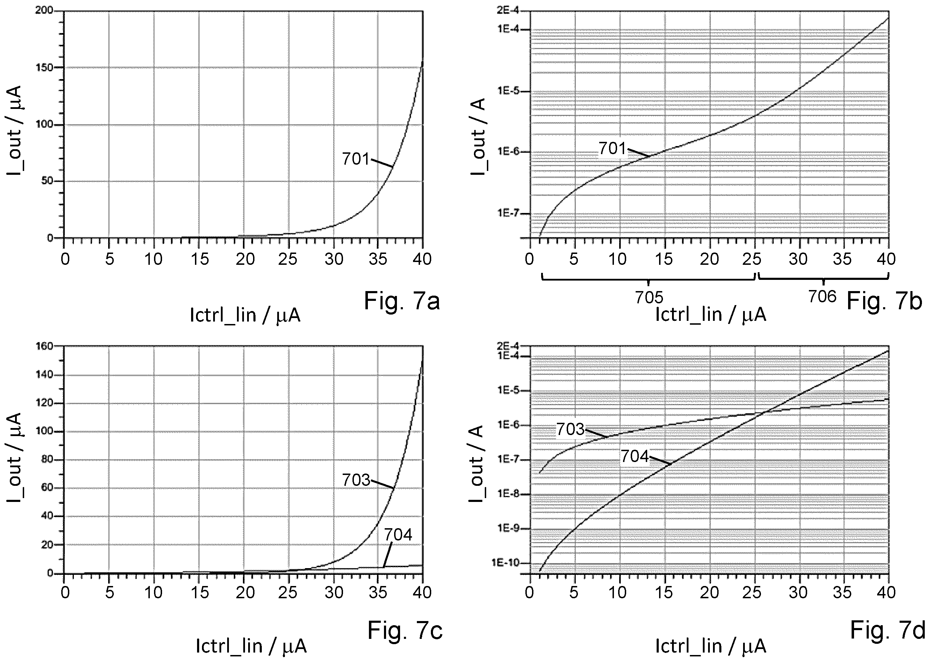

Figures 7a-7d illustrate how the output current I_out (in μA) varies as a function of linear input current Ictrl_lin, with Figures 7a and 7b showing a summed current output 701 in linear and log scales respectively and Figures 7c and 7d the separate current components Ictrl_exp1 703 and Ictrl_exp2 704 in linear and log scales respectively as a function of Ictrl_lin. As shown in Figure 7b, over a lower first range 705, in this case from 0 to around 25 μA, the first output current Ictrl_exp1 703 dominates the summed output current, while in a higher second range 706, in this case above around 25 μA, the second output current Ictrl_exp2 704 dominates the summed output current. These ranges correspond to VGA low and high gain settings respectively.

For the input control current Ictrl_in above around 15 μA, both Ictrl_exp1 and Ictrl_exp2 vary exponentially in relation to the linear input current Ictrl_lin. The relationship between the output currents Ictrl_exp1 and Ictrl_exp2 (in log) in this case have difference slopes. In this example, when Ictrl_lin < 25 μA, the output summed current Ictrl_sum is dominated by Ictrl_exp1, and when Ictrl_lin > 25 μA, the summed output current Ictrl_sum is dominated by Ictrl_exp2.

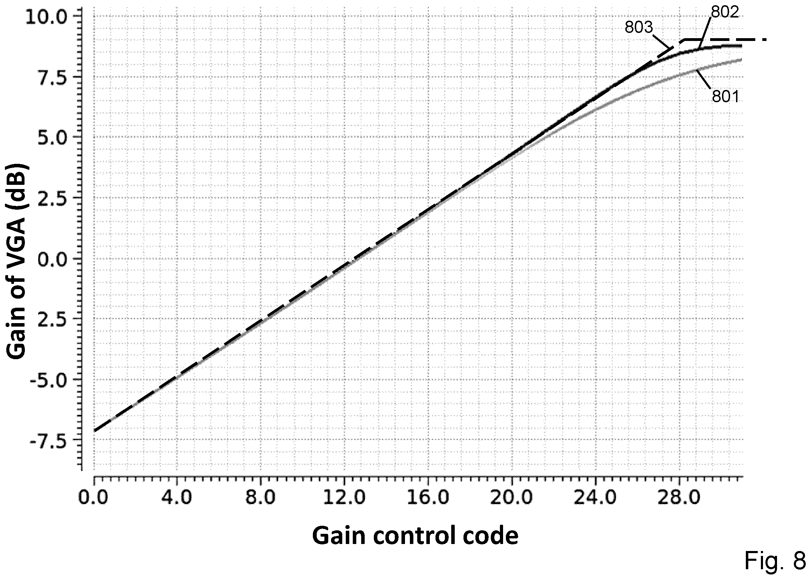

Figure 8 illustrates an example plot of VGA gain as a function of gain control code for the VGA provided with a summed current Ictrl_sum from a current converter of the type described above in relation to the example in Figure 6 compared to the VGA provided with a current from a converter of the previous type described above in relation to the example in Figure 4. The gain 801 from the previous type of converter shows a departure from linearity above an input code of around 20, while the gain 802 from the summed current converter circuit shows an increased linear region up to around 26. This demonstrates a wider VGA linear gain control range for the summed current output converter circuit, which is closer to the ideal case 803.

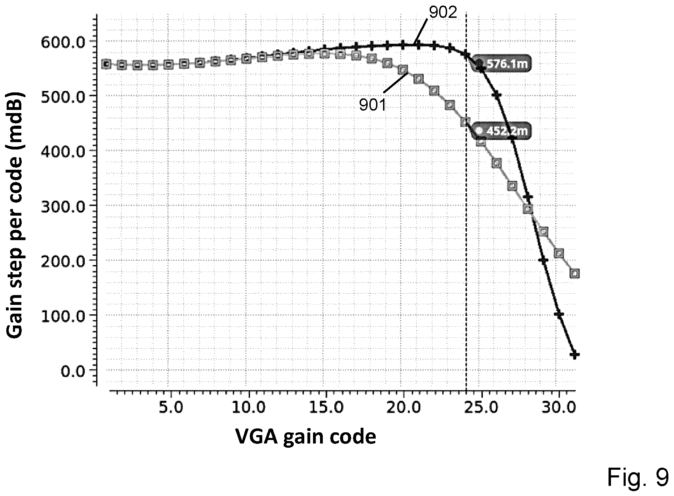

Figure 9 illustrates the difference in performance by plotting the gain step per unit code as a function of VGA gain code, showing that the gain step 901 for the previous converter drops off at a lower gain code compared to the gain step 902 for the summed current converter. This shows that the gain step drops by around 0.1-dB (from 0.55-dB to 0.45-dB) with a gain code of 24 for the previous current converter, while the gain step is still constant with the summed current converter.

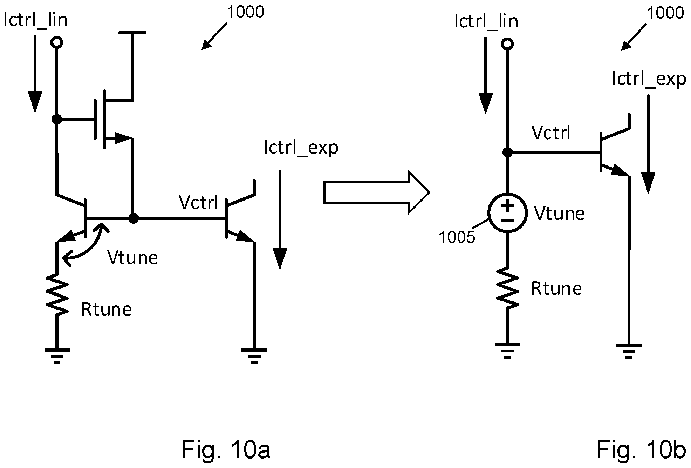

Figures 10a and 10b illustrate an example I2I circuit 1000 to explain the operation principles of the circuit and indicate alternative example arrangements. The circuit diagram in Figure 10a indicates the components of the example current converter circuits in Figures 4 and 6. This can be simplified to the schematic circuit in Figure 10b, in which the tuning voltage circuit 1005 is indicated as a single component.

*VBE* Applying the basic formula for an NPN transistor $I_C \approx I_{En} = I_S \times e^{\frac{V_{BE}}{V_T}}$ , the output current Ictrl_exp can be expressed as $I_{ctrl\_exp} \approx I_S \times e^{\frac{I_{ctrl\_lin} \times R_{tune} + V_{tune}}{V_T}}$ . The output current thereby varies exponentially as a function of the linear input current Ictrl_lin, and can be tuned by the tuning resistor value Rtune and tuning voltage valve Vtune.

Following the above calculation, taking the natural logarithm for both sides of the equation above results in:

$$\ln(I_{ctrl\_exp}) \approx \ln(I_S) + \frac{I_{ctrl_{lin}} \times R_{tune} + V_{tune}}{V_T}$$

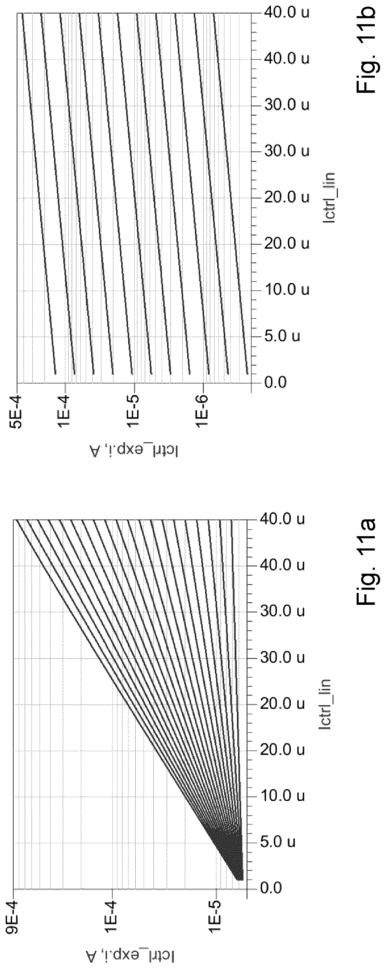

The logarithm of the output current Ictrl_exp should therefore be proportional to the tuning resistor value Rtune and to the tuning voltage Vtune. The relationship between Ictrl_exp in log scale as a function of Ictrl_lin in linear scale is shown in Figures 11a and 11b, with Figure 11a showing different relationships for different Rtune values with a fixed Vtune value and Figure 11b showing different relationships for different Vtune values with a fixed Rtune value. These illustrate that the slope of the curve for each current converter can be adjusted by changing Rtune, and the level of the curve can be shifted up or down by changing Vtune.

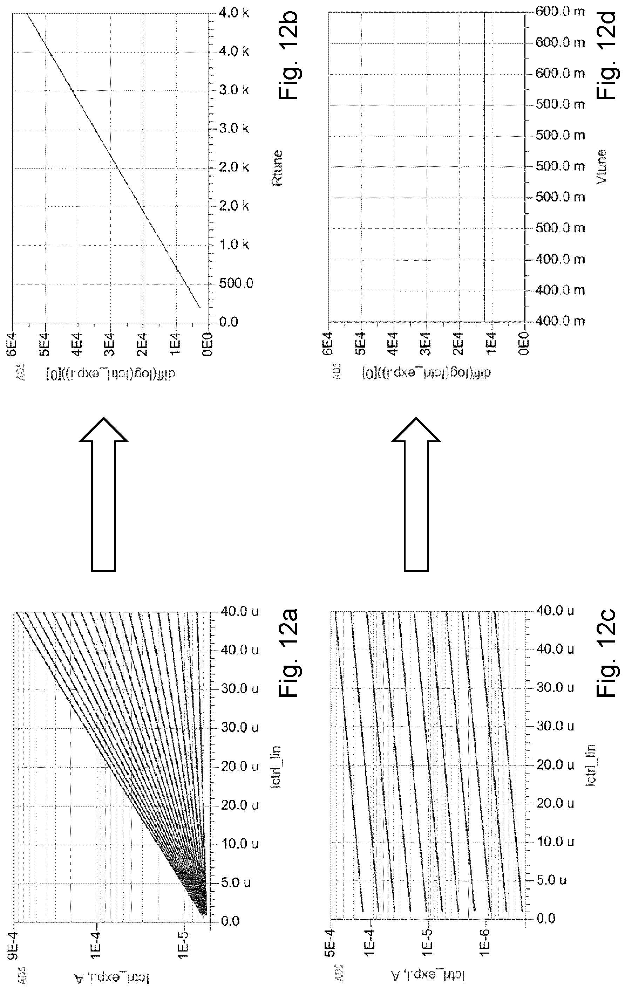

Figures 12a-12d further illustrate the effect of adjusting Vtune and Rtune. Figure 12a shows the different relationships with different Rtune values and a fixed Vtune value and Figure 12b shows the relationship between the derivative of the output current as a function of Rtune, i.e. the slope of the curves in Figure 12a. Figure 12c shows the different curves from varying the Rtune value while keeping Vtune fixed and Figure 12d shows that the derivative of the output current stays constant over the range of Vtune values. As a result, a design procedure for optimising the current converter circuit can involve firstly tuning Rtune for the desired slope and then tuning Vtune for the desired offset value.

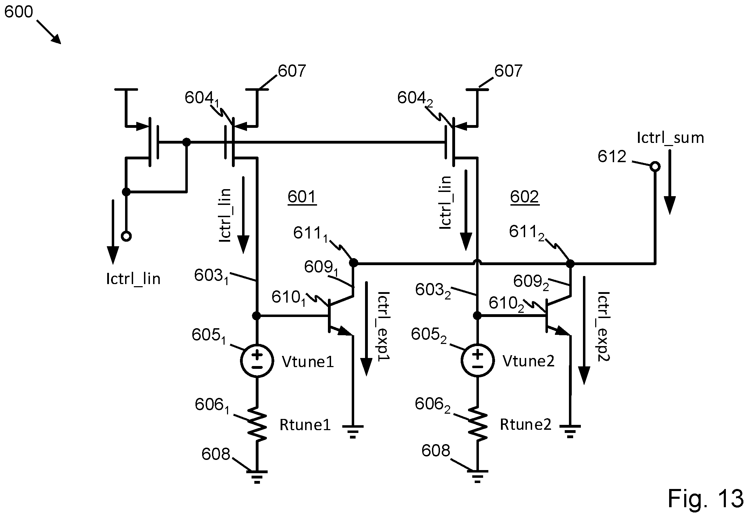

Based on the analysis above, the operational principle of the current converter in Figure 6 can be simplified to that illustrated in Figure 13, in which the same reference signs as in Figure 6 are used to indicate corresponding components. In a practical design, a diode-connected NPN transistor and a diode-connected MOS transistor, as illustrated in Figure 6, can be used to generated different voltage drops Vtune1 and Vtune2, and different resistors Rtune1 and Rtune2 can be used to control the slopes of the exponentially varying output control current Ictrl_exp (in log scale) as a function of the linearly varying input control current Ictrl_lin.

In an ideal case, the values of Vtune1 and Vtune2 should be independent of the linear input control current Ictrl_lin, which is not completely accurate with a diode-connected transistor. However, since the voltage drop across the resistors (Rtune1 and Rtune2) is proportional to Ictrl_lin, the voltage drop across the diodes (Vtune1 and Vtune2) is approximately constant over the variation in Ictrl_lin.

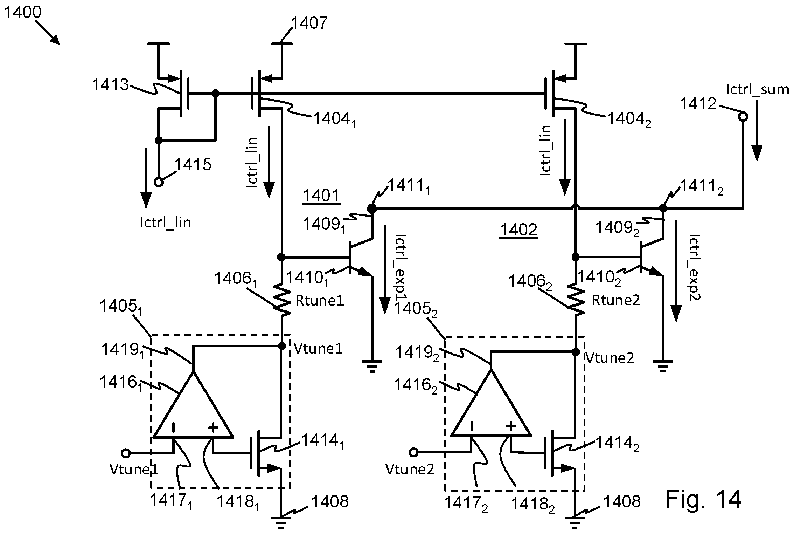

In an alternative arrangement, Figure 14 illustrates an example of a current converter circuit 1400 in which the tuning voltage circuit $1405_1$, $1405_2$ in each of the first and second current converters 1401, 1402 comprises an LDO (low dropout) voltage regulator $1416_1$, $1416_2$ and a tuning transistor $1414_1$, $1414_2$ to buffer Vtune1 and Vtune2 values that are provided as inputs to the first and second current converters 1401, 1402. This makes the tuning voltages Vtune1, Vtune2 independent of the input linear control current Ictrl_lin. The voltage regulators $1416_1$, $1416_2$ each have a first input $1417_1$, $1417_2$ for receiving a tuning voltage signal Vtune1, Vtune2 and a second input $1418_1$, $1418_2$ con-

nected to a gate of the tuning transistor $1414_1$, $1414_2$. An output $1419_1$, $1419_2$ of the voltage regulator $1416_1$, $1416_2$ is connected to a drain of the tuning transistor $1414_1$, $1414_2$. A source of the tuning transistor $1414_1$, $1414_2$ is connected to the common voltage line 1408. Other components of the first and second current converters 1401, 1402 of the current converter circuit 1400, together with their connections, are similar to corresponding components of the current converter circuit 600 described above, including the output current branch $1409_1$, $1409_2$, output transistor $1410_1$, $1410_2$, output node $1411_1$, $1411_2$, summing output node 1412, input current source transistor 1413 and input node 1415.

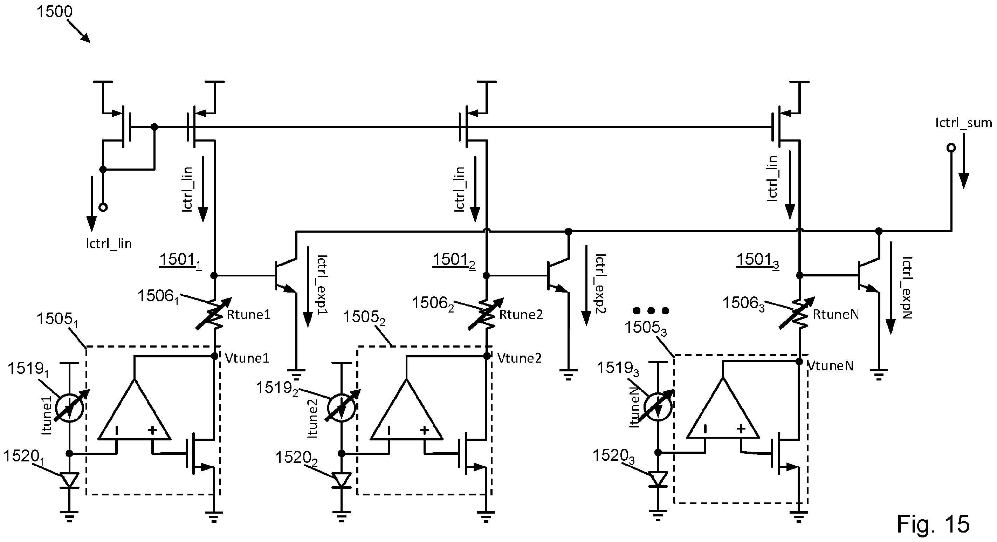

The number of current converters making up the current converter circuit is not necessarily limited to two and in some examples the current converter circuit may have three or more current converters arranged in parallel. Figure 15 illustrates an example alternative current converter circuit 1500 with three (or more) current converters $1501_1$, $1501_2$, $1501_3$. Each current converter may be similar to the current converters 1401, 1402 described above in relation to Figure 14, or may be similar to the current converters 601, 602 described above in relation to Figure 6. The tuning voltage circuits $1505_1$, $1505_2$, 1505s in the illustrated example are provided with a tuning voltage signal from a variable current source $1519_1$, $1519_2$, $1519_3$ in series with a diode $1520_1$, $1520_2$, 1520s. Adjusting the current itune1, itune2, itune3 through the current sources $1519_1$, $1519_2$, 1519s adjusts the tuning voltage Vtune1, Vtune2, Vtune3 applied to the tuning voltage circuits $1505_1$, $1505_2$, 1505s. The diodes may be implemented using diode-connected transistors, which may for example be bipolar or MOS transistors.

Other components of each of the current converters $1501_{1-3}$, together with their relative connections, may be similar to those in the examples described above in Figures 6 and 14.

The tuning resistors $1506_{1-3}$ may themselves be tuneable, such that the tuning resistance values Rtune1, Rtune2, Rtune3 are adjustable, thereby allowing the current converter circuit to be reconfigurable to adjust the slope of each portion of the gain range.

From reading the present disclosure, other variations and modifications will be apparent to the skilled person. Such variations and modifications may involve equivalent and other features which are already known in the art of current converters, gain control circuits and/or variable gain amplifiers, and which may be used instead of, or in addition to, features already described herein.

Although the appended claims are directed to particular combinations of features, it should be understood that the scope of the disclosure of the present invention also includes any novel feature or any novel combination of features disclosed herein either explicitly or implicitly or any generalisation thereof, whether or not it relates to the same invention as presently claimed in any claim and whether or not it mitigates any or all of the same technical problems as does the present invention.

Features which are described in the context of separate embodiments may also be provided in combination in a single embodiment. Conversely, various features which are, for brevity, described in the context of a single embodiment, may also be provided separately or in any suitable sub-combination. The applicant hereby gives notice that new claims may be formulated to such features and/or combinations of such features during the prosecution of the present application or of any further application derived therefrom.

For the sake of completeness it is also stated that the term "comprising" does not exclude other elements or steps, the term "a" or "an" does not exclude a plurality, a single processor or other unit may fulfil the functions of several means recited in the claims and reference signs in the claims shall not be construed as limiting the scope of the claims.

## Claims

1. A current converter circuit (600) for converting a linear input current (Ictrl_lin) to an exponential output current (Ictrl_sum), the current converter circuit (600) comprising first and second current converters (601, 602), each of which comprises:

   an input current branch ($603_1$, $603_2$) with an input current source ($604_1$, $604_2$) connected in series with a tuning voltage circuit ($605_1$, $605_2$) and a tuning resistor ($606_1$, $606_2$) between a supply voltage line (607) and a common voltage line (608); and
   an output current branch ($609_1$, $609_2$) with an output transistor ($610_1$, $610_2$) having a collector connected to an output node ($611_1$, $611_2$), an emitter connected to the common voltage line (608) and a base connected to the tuning voltage circuit ($605_1$, $605_2$),
   wherein the output nodes ($611_1$, $611_2$) of the first and second current converters (601, 602) are connected to a summing output node (612) of the current converter circuit (600).

2. The current converter circuit (600) of claim 1, wherein the tuning voltage circuit ($605_1$, $605_2$) of each of the first and second current converters (601, 602) comprises a diode-connected NPN transistor ($612_1$, $612_2$) and a diode-connected MOS transistor ($614_1$, $614_2$).

3. The current converter circuit (600) of claim 2, wherein the diode-connected NPN transistor is an input transistor ($612_1$, $612_2$) having a collector connected to the input current source ($604_1$, $604_2$), an emitter connected to the tuning resistor ($606_1$, $606_2$) and a base connected to the base of the output transistor ($610_1$, $610_2$).

4. The current converter circuit (600) of claim 3, wherein the diode connected MOS transistor is a tuning transistor ($614_1$, $614_2$) having a gate connected to the input current source ($604_1$, $604_2$), a source connected to the base of the input and output transistors ($612_1$, $612_2$, $610_1$, $610_2$) and a drain connected to the supply voltage line (607).

5. The current converter circuit (1400) of claim 1, wherein the base of the output transistor ($1410_1$, $1410_2$) of each of the first and second current converters (1401, 1402) is connected to the tuning voltage circuit ($1405_1$, $1405_2$) via the tuning resistor ($1406_1$).

6. The current converter circuit (1400) of claim 5, wherein the tuning voltage circuit ($605_1$, $605_2$) of each of the first and second current converters (601, 602) comprises a voltage regulator ($1416_1$, $1416_2$) and a tuning transistor ($1414_1$, $1414_2$), the voltage regulator ($1416_1$, $1416_2$) having a first input ($1417_1$, $1417_2$) for receiving a tuning voltage signal (Vtune1, Vtune2) and a second input ($1418_1$, $1418_2$) connected to a gate of the tuning transistor ($1414_1$, $1414_2$), an output ($1419_1$, $1419_2$) of the voltage regulator ($1416_1$, $1416_2$) connected to a drain of the tuning transistor ($1414_1$, $1414_2$) and a source of the tuning transistor ($1414_1$, $1414_2$) connected to the common voltage line (1408).

7. The current converter circuit (600, 1400) of any preceding claim, wherein the tuning resistor ($606_1$, $606_2$) of each of the current converters (601, 602) is adjustable.

8. The current converter circuit (600) of claim 1 or claim 2, wherein the input current source of each of the first and second current converters (601, 602) comprises a current source transistor ($604_1$, $604_2$) having a gate connected to an input node (615) of the current converter circuit (600), a source connected to the supply voltage line (607) and a drain connected to the tuning voltage circuit ($605_1$, $605_2$).

9. A gain control circuit for a variable gain amplifier, comprising:

   a current converter circuit (303) according to any preceding claim;
   a current to voltage converter circuit (304) connected to the output current branch ($609_1$, $609_2$) and configured to convert an output current through the output current branch ($609_1$, $609_2$) to a differential output voltage signal.

10. The gain control circuit of claim 9, wherein the current to voltage converter circuit is a complementary differential amplifier configured to convert a single-ended current from the output current branch ($609_1$, $609_2$) to the differential output voltage signal.

11. A variable gain RF amplifier (103) comprising:

    an RF input;
    an RF output;
    a Gilbert Cell amplifier (201) connected between the RF input and RF output; and
    a gain control circuit according to claim 9 or claim 10, wherein the differential output signal is connected to control a gain of the Gilbert Cell amplifier (201).

12. A transmitter (100) comprising a plurality of channels ($101_1$, $101_2$), each channel ($101_1$, $101_2$) comprising a variable gain RF amplifier (103) according to claim 11, a power amplifier (106) and an antenna (107).

13. The transmitter (100) of claim 12, wherein each of the plurality of channels ($101_1$, $101_2$) comprises a coarse phase shifter (104) and a fine phase shifter (105), the variable gain RF amplifier (103), coarse phase shifter (104) and fine phase shifter (105) connected in line to provide an amplified phase shifted signal to the power amplifier (106).

Fig. 1

TX channel1 $101_1$

100

101

100

TX channel2 $101_2$

PI-VGA

103

0-to-90-degree phase shifter (with small steps)

104

0/90 degree phase shifter (with coarse step)

105

106

PA

107

RFout ○—204

Output Matching Network  206

207

cb_top bias circuit

Vcas_top

103

201

209        210

202

Gain & Phase control circuit

Vcas_vga_p

218

Vcas_vga_n

219

211  212    213  214

208a

ce bias circuit

215        216        217

208b

ce Vbe bias circuit

217

Input Matching Network  205

RFin ○—203

Fig. 2

EP 4 708 682 A1

10

202

301

**Digital circuit**
- Generate linear control code

302

**IDAC**
- Current-DAC
- generate current linear to control code

Ictrl_lin

303

**I2I (Current-to-Current) conversion**
- linear to exponential

Ictrl_exp

304

**I2V (Current-to-Voltage) conversion**
- Single-ended current to differential (commentary) voltage
- Voltage (VGA phase) swapping

Vcas_vga_p

218

219

Vcas_vga_n

Fig. 3

Fig. 4

EP 4 708 682 A1

Fig. 5

EP 4 708 682 A1

Fig. 6

EP 4 708 682 A1

14

Fig. 7a

Fig. 7b

Fig. 7c

Fig. 7d

EP 4 708 682 A1

Fig. 8

Fig. 9

Fig. 10a

Fig. 10b

Fig. 11b

Fig. 11a

Fig. 12b

Fig. 12d

Fig. 12a

Fig. 12c

Fig. 13

Fig. 14

EP 4 708 682 A1

Fig. 15

Ictrl_sum

Ictrl_expN

Ictrl_lin

RtuneN

VtuneN

$1501_3$

$1506_3$

$1505_3$

$1519_3$  ItuneN

$1520_3$

Ictrl_exp2

Ictrl_lin

Rtune2

Vtune2

$1501_2$

$1506_2$

$1505_2$

$1519_2$  Itune2

$1520_2$

Ictrl_exp1

Ictrl_lin

Rtune1

Vtune1

$1501_1$

$1506_1$

$1505_1$

$1519_1$  Itune1

$1520_1$

Ictrl_lin

1500

# EUROPEAN SEARCH REPORT

**Application Number**

EP 24 19 9474

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2003/112072 A1 (KIM SEONG-RYEOL [KR]) 19 June 2003 (2003-06-19) | 1-7,9-13 | INV. H03G1/00 |
| A | * paragraphs [0001] - [0078]; figures 1-10 * | 8 | H03F3/45 G06G7/12 G06G7/24 |
| A | US 6 215 989 B1 (OTAKA SHOJI [JP]) 10 April 2001 (2001-04-10) * column 1, line 27 - column 13, line 12; figures 1-10 * | 1-13 | H03G7/06 H03G3/30 |
| A | BARRIE GILBERT: "The Multi-tanh Principle: A Tutorial Overview", IEEE JOURNAL OF SOLID-STATE CIRCUITS, IEEE, USA, vol. 33, no. 1, 1 January 1998 (1998-01-01), XP011060641, ISSN: 0018-9200 * page 14, right-hand column, line 5 - page 15, right-hand column, line 4; figure 21 * | 1-13 | |
| A | HUI DONG LEE ET AL: "A Wideband CMOS Variable Gain Amplifier With an Exponential Gain Control", IEEE TRANSACTIONS ON MICROWAVE THEORY AND TECHNIQUES, IEEE, USA, vol. 55, no. 6, 1 June 2007 (2007-06-01), pages 1363-1373, XP011185145, ISSN: 0018-9480, DOI: 10.1109/TMTT.2007.896787 * page 1363, left-hand column, line 18 - page 1372, right-hand column, line 22; figures 1-17 * | 1-13 | **TECHNICAL FIELDS SEARCHED (IPC)** H03F H03G G06G G06N |
| A | US 5 572 166 A (GILBERT BARRIE [US]) 5 November 1996 (1996-11-05) * column 1, line 6 - column 8, line 9; figures 1-7B * | 1-13 | |

The present search report has been drawn up for all claims

| Place of search | Date of completion of the search | Examiner |
|---|---|---|
| The Hague | 27 February 2025 | Fedi, Giulio |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 24 19 9474

This annex lists the patent family members relating to the patent documents cited in the above-mentioned European search report.
The members are as contained in the European Patent Office EDP file on
The European Patent Office is in no way liable for these particulars which are merely given for the purpose of information.

27-02-2025

| Patent document cited in search report | | Publication date | Patent family member(s) | | Publication date |
|---|---|---|---|---|---|
| US 2003112072 | A1 | 19-06-2003 | JP | 4442746 B2 | 31-03-2010 |
| | | | JP | 2003198290 A | 11-07-2003 |
| | | | KR | 20030048776 A | 25-06-2003 |
| | | | US | 2003112072 A1 | 19-06-2003 |
| US 6215989 | B1 | 10-04-2001 | JP | 3469486 B2 | 25-11-2003 |
| | | | JP | 2000196386 A | 14-07-2000 |
| | | | US | 6215989 B1 | 10-04-2001 |
| US 5572166 | A | 05-11-1996 | AU | 6383196 A | 30-12-1996 |
| | | | DE | 69622971 T2 | 24-04-2003 |
| | | | EP | 0776548 A1 | 04-06-1997 |
| | | | JP | 4386460 B2 | 16-12-2009 |
| | | | JP | H10503917 A | 07-04-1998 |
| | | | US | 5572166 A | 05-11-1996 |
| | | | WO | 9641413 A1 | 19-12-1996 |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- **M. BAZES**. Two novel fully complementary self-biased CMOS differential amplifiers. *IEEE Journal of Solid-State Circuits*, February 1991, vol. 26 (2), 165-168